# EUROPEAN PATENT APPLICATION

(11) **EP 0 791 813 A2**
(43) Date of publication of application: **27.08.1997**
(21) Application number: 97301185.1
(22) Date of filing: 24.02.1997
(51) Int. Cl.: G01L 9/00

(54) **Semiconductor acceleration or pressure sensor**

(30) Priority: 22.02.1996 JP 34703/96
(71) Applicant: Seiko Instruments R&D Center Inc., Chiba-shi, Chiba (JP)
(72) Inventor: Shinogi, Masataka, Mihama-ku, Chiba-shi, Chiba (JP); Saitoh, Yukata, Mihama-ku, Chiba-shi, Chiba (JP); Kato, Kenji, Mihama-ku, Chiba-shi, Chiba (JP)
(74) Representative: Sturt, Clifford Mark

(57) **Abstract**

In order to reduce processing degeneration or microcracks, a method of forming a semiconductor acceleration sensor comprises:
a. providing a semiconductor substrate (1) and forming a recess (7) in a first surface of the substrate in order to provide a substrate portion (12) for movement in response to the application of acceleration or pressure;
b. wherein the recess is formed by cutting with a cutting blade means (5) while applying a liquid containing fine abrasive particles (3) to the cutting area, and applying an electric field in order to move the abrasive particles by electrophoresis towards the cutting blade means; and
c. forming one or more electrical elements (2) on a second surface of the substrate for sensing movement of said substrate portion.

## Description

The present invention relates to a semiconductor device for converting displacement into an electric signal, e.g. by utilizing a piezo resistance effect included in a semiconductor crystal such as silicon and more particularly to an acceleration sensor and a pressure sensor thereof.

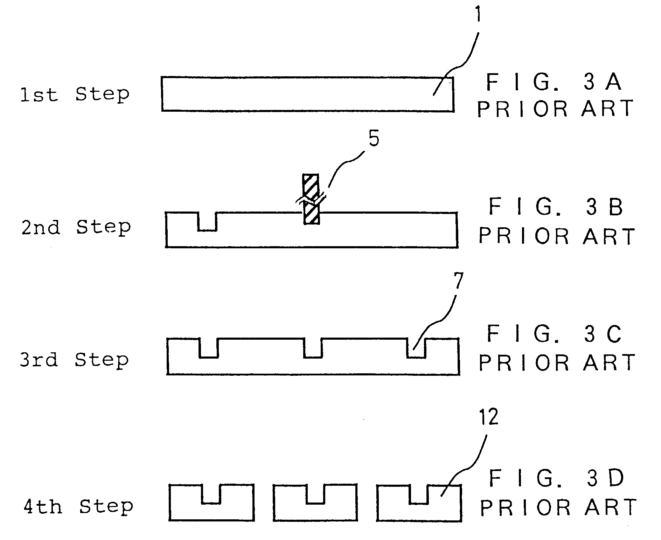

Fig.s 3 show a method of manufacturing a semiconductor acceleration sensor provided with a diaphragm portion disclosed in Japanese Patent Provisional Publication Number HFI4-9628O. A diaphragm is produced by applying mechanical processing to a semiconductor substrate. In the process, a semiconductor substrate 1 completed with formation of a strain gage is prepared in Fig.3A. Grooves 7 having an appropriate thickness are formed mechanically from the back side using a blade 5 such as rotary blade in a region to form a diaphragm portion adapting to a pattern of a strain gage from the back (shown as the top) of the semiconductor substrate 1 where no strain gage is formed in Fig. 3B. After grooves 7 are formed in all of the predetermined regions, chemical etching is applied in order to remove mechanical damage, thus forming a diaphragm portion in Fig. 3C. Finally, the semiconductor substrate 1 on which the diaphragm portion has been formed is cut apart into individual chips in Fig. 3D.

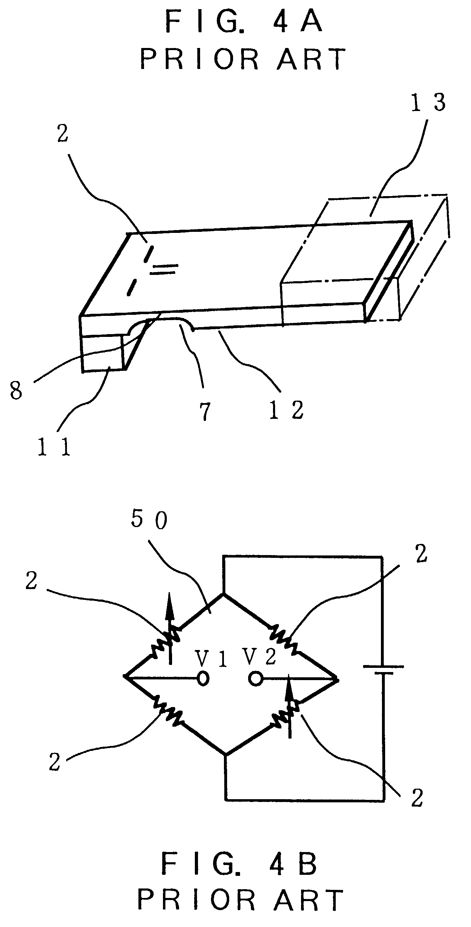

Fig. 4A is a view showing a semiconductor acceleration sensor produced bv micromachining disclosed in Japanese Patent Provisional Publication Number HEI1-302167, in which a groove portion 7 is formed in the vicinity of a supporting bodv 11 of cantilever 12, thus providing a thin wall portion 8. Diffused resistors 2 are provided on the top of the sensor, thus forming a bridge circuit 50. These diffused resistors are formed on the groove portion. The bridge circuit is shown in Fig. 4B. In this semiconductor acceleration sensor, the groove portion of the detecting portion has been formed by isotropic etching. The groove portion 7 is said to be formed using hydrofluoric acid as an etchant.

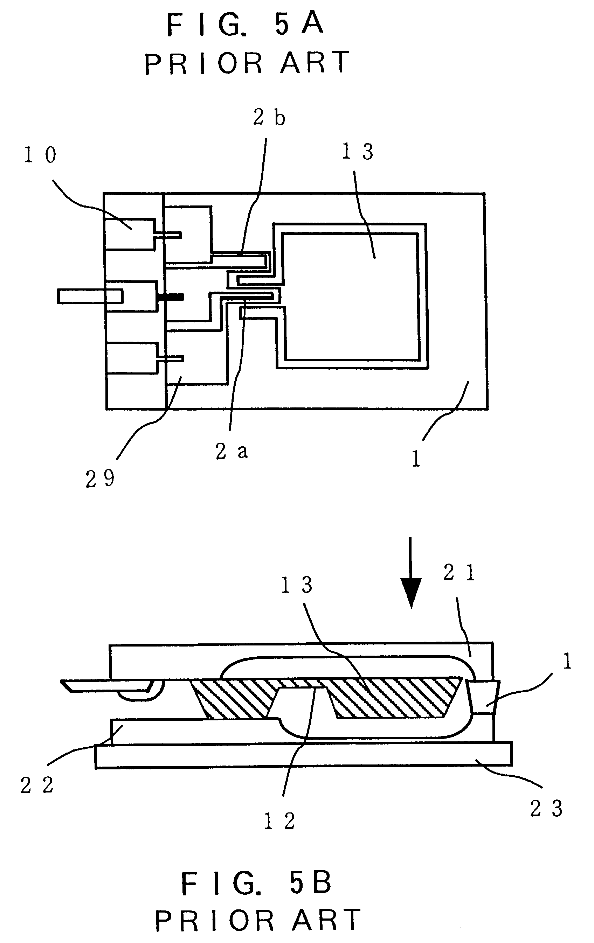

IEEE Transactions on Electron Devices, Vol. ED-26, No.12, Dec.1979 describes a typical method of manufacturing a semiconductor acceleration sensor. Fig. 5 shows a conventional semiconductor acceleration sensor by micromachining. Fig. 5A is a top view, and Fig. 5B is a sectional view. In this acceleration sensor, the silicon substrate 1 is etched, and a cantilever 12 including an overlapping 13 are formed. Here, the thickness of the cantilever 12 is formed thinner than other portions by etching, and the cantilever 12 is transformed against the acceleration in a direction of an arrow shown in Fig. 3B. Further, the transformation quantity of the cantilever 12 is detected by a piezo resistance effect of a diffused resistor 2a formed on the top of the cantilever 12, and the acceleration is obtained through comparison with a diffused resistor 2b. Here, the diffused resistors 2a and 2b are connected to a high concentration diffused region 9 and an output terminal 10. Further, in order to prevent destruction of the cantilever 12, an upper stopper 21 and a lower stopper 22 are arranged, and the whole body is arranged further on a ceramic substrate 23. Further, there is an example of producing a semiconductor acceleration sensor by micromachining in recent years, but when a diaphragm was formed by mechanical processing, mechanical damage and microcracks were produced, and it has been required to apply chemical etching in order to remove an degenerated layer after processing was completed. When etching is performed, it is required to form an opening portion by photolithography on the back and to etch silicon for the purpose of forming a groove portion. There have been such problems that photolithography is required on inside and outside thus causing the subject of manufacturing facilities, and that processes such as formation of a protective film and pattern formation on the back for the purpose of preventing damages on other portions by the etching process.

The present invention has been made for the purpose of solving such problems, and is able to simply form a groove portion of a detecting portion of a semiconductor acceleration sensor and contributes to reduction in cost.

### SUMMARY OF THE INVENTION

The present invention provides a method of forming a semiconductor device for use in a sensor as set forth in claim 1.

In the semiconductor acceleration sensor according to the present invention, a groove portion of the detecting portion was formed by mechanical cutting. Since it is required to control the thickness of the thin wall portion in particular, electrolysis and abrasive grains were used on a cutting blade and that portion was cut by an electrophoresis phenomena of cutting abrasive grains. Further, a binding agent forming the cutting blade elutes in a process of applying electrolysis to the cutting blade for mechanical cutting, and the abrasive grains of the cutting blade are projected. Furthermore, cutting was made by that the projection is restricted by means of nonconducting film formation.

### BRIEF DESCRIPTION OF THE DRAWINGS

Figs. 1 are process diagram showing a method of manufacturing a semiconductor acceleration sensor according to the present invention;
Fig. 2 is a perspective view of a semiconductor acceleration sensor according to the present invention;
Figs. 3 are process diagram showing a conventional method of manufacturing a semiconductor acceleration sensor;
Figs. 4 are perspective view and a bridge circuit of a conventional semiconductor acceleration sensor;
Figs. 5 are top view and a sectional view of a conventional semiconductor acceleration sensor;
Figs. 6 are process diagram showing a conventional method of manufacturing a semiconductor acceleration sensor;
Fig. 7 is an explanatory diagram for explaining an electrophoresis phenomenon of an embodiment according to the present invention;
Fig. 8 an explanatory diagram for explaining a dicing apparatus of an embodiment according to the present invention;
Fig. 9 an explanatory diagram for explaining a dicing method of an embodiment according to the present invention;
Fig. 10 is an explanatory diagram for explaining a dicing method ofan embodiment according to the present invention;
Fig. 11 is a perspective view of a semiconductor acceleration sensor of an embodiment according to the present invention;
Fig. 12 is a sectional view of a blade used in the present invention; and
Figs. 13 are explanatory diagrams for explaining an electrolysis in-process of the present invention.

### DETAILED DESCRIPTION OF THE PREFERRED EMBODIMENTS

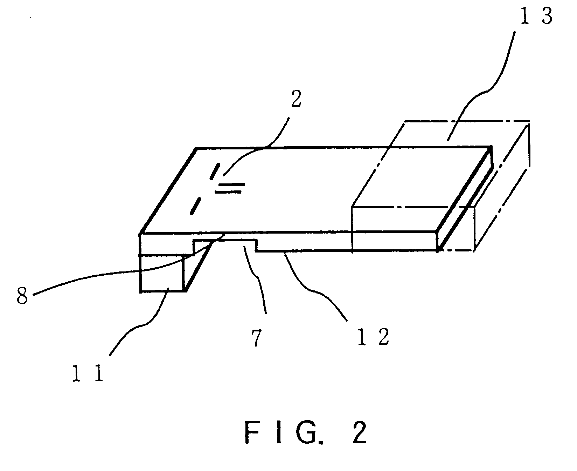

Embodiments of the present invention will be described hereinafter with reference to the drawings. Fig. 2 is a perspective view showing a structure of an embodiment of a semiconductor acceleration sensor according to the present invention This embodiment is composed of a cantilever 12 for detecting a stress, a supporting body 11 for supporting the lever portion, an overlapping 13 which is a mass portion, and diffused resistors 2 provided for detecting displacement against the stress applied to the cantilever 12. The diffused resistor portion being responsive to displacement, a groove portion is formed on the back side in order to improve sensitivity. The diffused resistors are formed of a bridge circuit 50 in Fig. 4B. In the present structure, the supporting body 11 is mounted in a package so as to form a semiconductor acceleration sensor. When acceleration is applied to the cantilever 12, the cantilever is bent and the resistance value of the diffused resistor 2 is changed, thus the acceleration is detected bv obtaining the change of the resistance value as output voltage. Furthermore, a temperature compensation circuit and an output amplification circuit are formed on the cantilever.

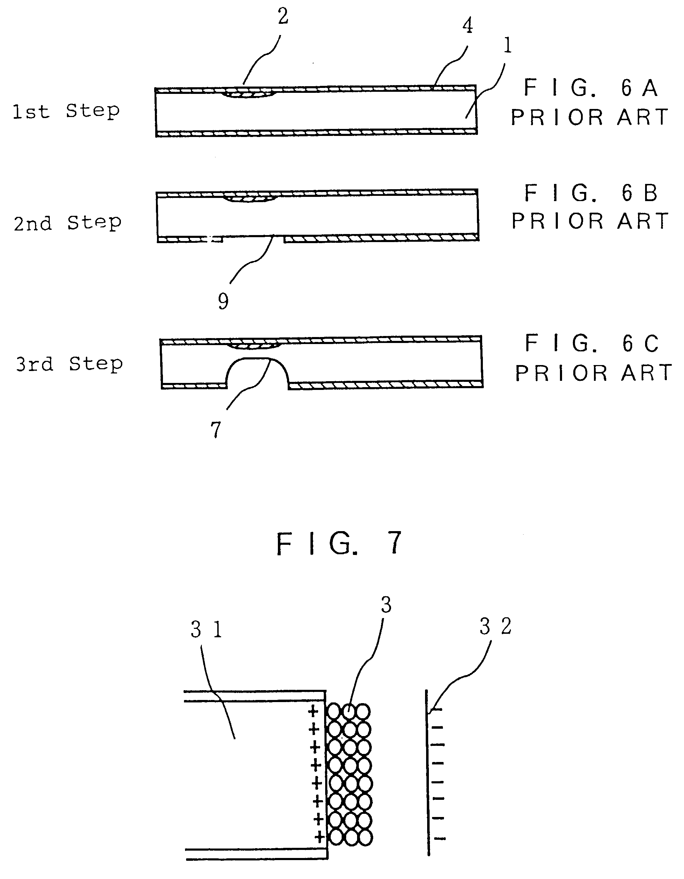

Fig. 6 shows a conventional method of manufacturing a semiconductor acceleration sensor wherein diffused resistors 2 and wirings are manufactured, and etching for making the wall of the diffused resistor portion thinner is also employed, but it is required to provide a pattern opening portion 9 for passing through an etchant to the back portion of the diffused resistors 2. Thus, since patterning on both sides is required, facilities for that purpose are required. Further, a protective film for protecting from the etchant is formed on the surface on the diffused resistor side. It is required for the protective film to perform condition setting of the film quality accurately in order to avoid permeation of the etchant from cracks or the like of the film. Because of such issues, the wall of the diffused resistor portion was made thinner by mechanical cutting in the present invention. According to a method of manufacturing according to the present invention, a process of photolithography for forming diffused resistors and wirings on one side only is sufficient and it is sufficient to perform patterning for the semiconductor acceleration sensor to function in a first step and to perform mechanical cutting for making the diffused resistor portion thinner in wall thickness in a second step, and it is possible to measure processing measurements or the like easily on the way of production.

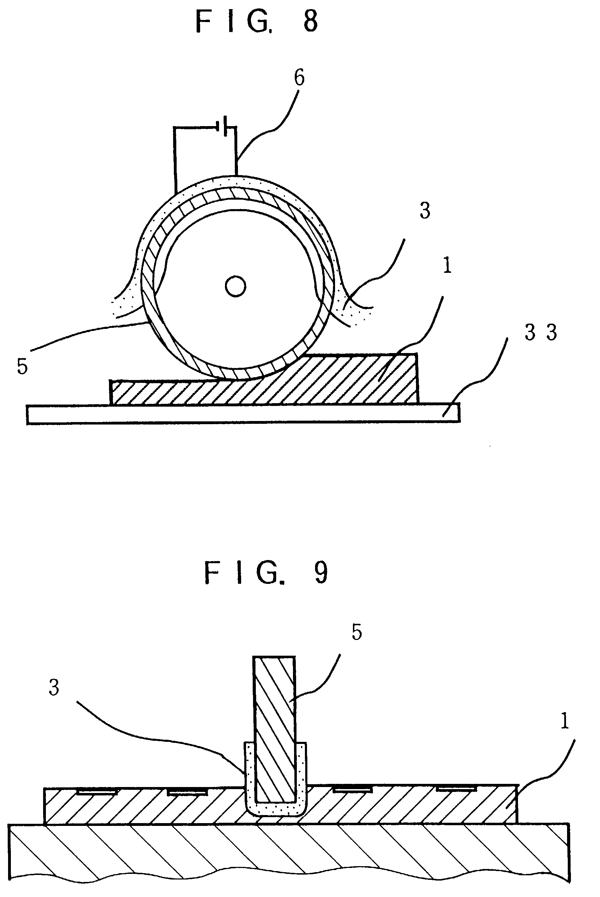

In a dicing method in which water is used for normal cutting water, however, athough it is possible to cut out the cantilever 12, there are problems of a processing degenerated layer and chipping. Therefore, following methods have been adopted in the present embodiment in order to further improve precision. If cutting resistance to elements is increased when elements are cut out in a cutting process of the semiconductor substrate 1, chipping is produced in the elements thus destructing the elements, and a case that the elements are not finished to desired dimensions. In order to cope with such subjects, electrophoresis phenomena of superfine abrasive grains 3 are utilized, as will be described. Referring to Figure 7, superfine silica abrasive grains are used for a cutting liquid. The superfine silica abrasive grains are charged negatively. Therefore, when an electric field operates thereon, silica migrates toward an anode 31, but does not reach to a cathode 32. There are superfine silica abrasive grains at the charged electrode of the anode 31. Silica grains 3 of colloidal silica bring about an adsorption phenomenon electrically on the electrode surface. While the electric field is in operation, an adsorption layer is formed continuously on the electrode surface. In other words, it is possible to form an adsorption layer of superfine silica abrasive grains easily by generating an electric field on a blade 5, thus making it possible to perform processing with less cutting resistance The structure of the apparatus used in the present embodiment is shown in Fig. 8. The apparatus is structured of a mechanism for supplying an abrasive material 3 to the dicing or cutting blade 5 and a DC power source 6 for applying a voltage to the dicing blade 5 provided on a dicing apparatus. A silica layer is produced on the blade 5 by supplying colloidal silica to the blade 5 and applying a positive voltage to the blade 5 by the DC power source 6. A semiconductor substrate 1 is installed on a chuck 33 and is cut with the dicing apparatus.

The processing using the present embodiment will be described with reference to Fig. 9. The dicing blade 5 descends from above the fixed semiconductor substrate 1, and comes into contact with the semiconductor substrate 1. At this time, superfine silica abrasive grains are supplied to the blade 5 as the abrasive material. The blade 5 is in a state that silica grains 3 are adsorbed. The grain diameter of the superfine silica abrasive grains is from 10 nm to 20 nm, and silica having such grain diameter charged on the anode 31 is adsorbed onto the dicing blade 5. An effect is shown by cutting the semiconductor substrate 1 in which this adsorption layer is a work, and very improved processing is presented.

When an element having above-mentioned dimensions was cut out in the present embodiment, it was found that the chipping quantity of 10 micron in conventional dicing had been improved to the quantity of 2 micron according to the present embodiment. With this, it is possible to supply stabilized elements of high yield that bring about neither disconnection of wirings nor destruction of diffused layers.

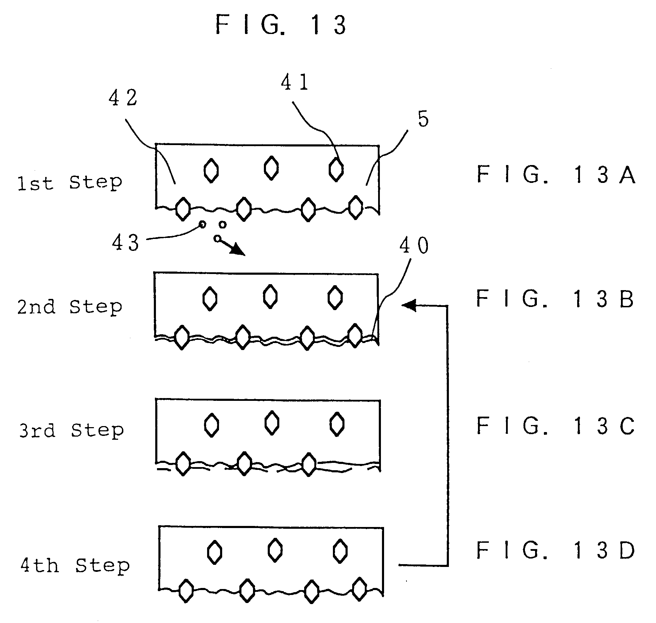

Further, as a method of reducing the chipping quantity, a dicing blade 5 in which cast iron is used for a bonding material 42 and including diamond grains 41 is used, and a voltage is applied to the dicing blade 5. A nonconducting film 40 is formed on an abrasive surface which prevents electrolysis and elusion of the bonding material 42, and certain abrasive grain protrusion is obtainable. The process is explained with reference to Fig. 13. In a first step, electrolysis is applied to the blade 5. The cast iron of the bonding material 42 of the blade 5 elutes as iron ions 43. After elution, oxidation is started, and the nonconducting film 40 is formed on the blade 5 surface (a second step). The diamond grains 41 are projected from the blade 5. Cutting is started in this state. When cutting is continued, the diamond grains 41 are debonded or the nonconducting film 40 is removed gradually. As a result, cutting environment is deteriorated. Here. the bonding material 42 elutes again (a third step) by means of electroiysis. Then, the nonconducting film 40 is formed (retuming to the second step). The second, the third and the fourth steps are repeated, thus facilitating cutting. This system is referred to as an electrolysis in-process.

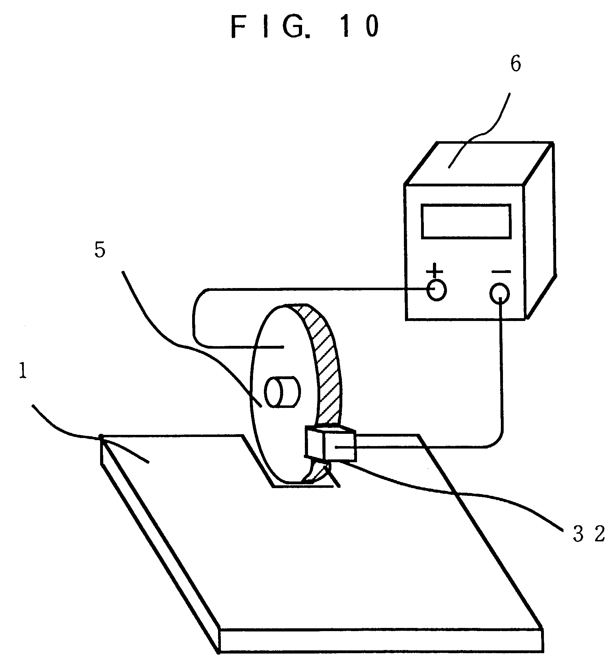

The structure of the apparatus this time is shown in Fig. 10. The structure of the apparatus consists of a structure of applying electrolysis to the dicing blade 5 by a cathode attachment 32 in the vicinity of the dicing blade 5 and a DC power source 6 connected between the blade 5 and the cathode 32. The semiconductor substrate 1 is cut by means of such a structure.

In the present embodiment, a fixing dicing tape for softening adhesive power by irradiating it with ultraviolet rays was used as a method of fixing the semiconductor substrate. With this, the semiconductor substrate 1 can be broken away easily and also can be fixed securely. It is possible to take out elements having little pitching and processing degenerated layers by cutting with a dicing apparatus by a method such as described above.

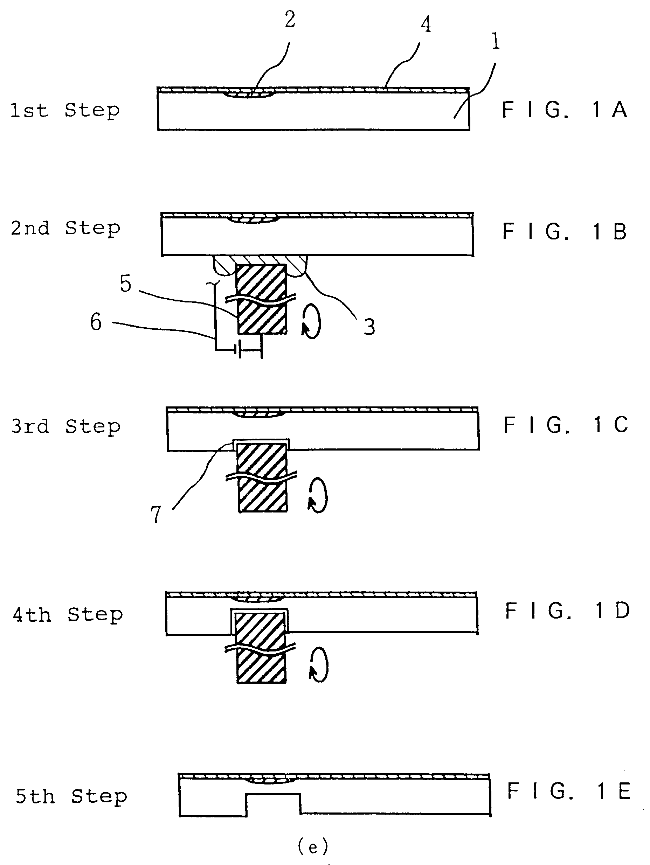

Fig. 1 shows a manufacturing process for a semiconductor acceleration sensor according to the invention. A diffused resistor 2 is formed on the semiconductor substrate 1 and passivation is formed in an upper layer 4 in Fig. 1A. In a second step, a blade 5 such as a rotary blade is used from the back of the diffused layer thereby to make the back thinner in wall thickness mechanically. At this time, colloidal silica is used for the cutting liquid, and voltage is applied to the blade 5 by means of the DC power source in Fig. 1B for electrolysis and forming a layer of particles 3 at the blade 5. In a third and a fourth step, the blade 5 continues to cut a semiconductor substrate 1. At this time, silica grains 3 of colloidal silica have been adsorbed to the blade 5, and the silica grains 3 come into contact with the semiconductor substrate 1 in Figs. 1C and D. Fig. 1E shows finish, but a diaphragm portion is formed, and a groove 7 having no processing degenerated layer is produced. Although description was made with respect to the cantilever 12 in the present embodiment, the present method is also effective in the case of a semiconductor substrate fixed at both ends but with a center lever portion responsive to acceleration. As the present embodiment, a semiconductor acceleration sensor having a lever portion 5 mm long, 2 mm wide and 0.03 thick at the thin wall portion was produced. The semiconductor acceleration sensor of the present embodiment showed the output voltage at 1 mV against the input voltage at 5 V. This output was almost equivalent to a theoretical value and satisfactory results were obtained without dispersion as compared with an etching process. A desired semiconductor acceleration sensor is obtainable easily in the present system as compared with micromachining

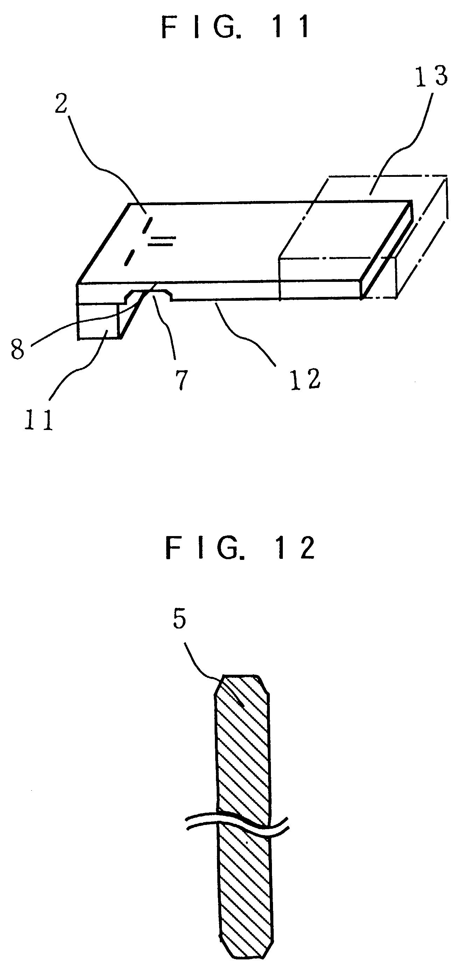

A dicing blade 5 having a perpendicular edge is used in the present embodiment, but it may be desirable to use a shape of a blade having taper angles or corner R at the corners as shown in Figure 12. By using such a blade 5, processing of a groove having a shape shown in Fig. 11 can be performed, thus avoiding stress concentration at the corner by the perpendicular blade and further increasing shock resistance.

With the present invention, by employing mechanical processing in a process of forming a thin wall portion in the diffused resistor for detecting a resistance value change by displacement, and electrolysis and electrophoresis phenomena of cutting abrasive grains are used for a cutting blade, excellent processing having neither processing degeneration nor microcracks can be performed. Further, by forming the sensor by a mechanical cutting method, the processing processes become less, thus resulting in reduction in the production cost. Since no chemicals such as strong acid are used, no damage is applied to wirings and so on, thus resulting in improvement of yield.

## Claims

1. A method of forming a semiconductor device for use in a sensor, comprising;
a. providing a semiconductor substrate (1) and forming a recess (7) in a first surface of the substrate in order to provide a substrate portion (12) for movement in response to the application of acceleration or pressure;
b. wherein the recess is formed by cutting with a cutting blade means (5) while applying a liquid containing fine abrasive particles (3) to the cutting area, and applying an electric field in order to move the abrasive particles by electrophoresis towards the cutting blade means; and
c. forming one or more electrical elements (2) on a second surface of the substrate for sensing movement of said substrate portion.

2. A method as claimed in claim 1, including coupling a DC power source (6) to the cutting blade in order to provide said electric field.

3. A method as claimed in claim 1 or 2, wherein said electric field is such that said abrasive particles form a layer on the surface of the cutting blade .

4. A method as claimed in any preceding claim, wherein said electric field creates an electrolysis effect wherein particles (43) of said cutting blade means are eluted, but wherein an insulating layer (40) is formed on the surface.

5. A method as claimed in any preceding claim, wherein said cutting blade means is a rotary cutting blade.

6. A method as claimed in claim 4, wherein the cutting blade has rounded or tapered edges for forming the recess.

7. A method according to any preceding claim, wherein said substrate portion forms a cantilever, and a portion of the substrate to the other side of the recess forms a fixing portion.

8. A method as claimed in any preceding claim, wherein the substrate is rectangular in form and said recess is cut across the width of the substrate on said one surface in order to provide a cantilever portion on one side of the recess and a fixing portion on the other side of the recess.

9. A method as claimed in any preceding claim wherein said electrical elements comprise one or more electrical resistors.

10. A method of manufacturing a semiconductor device having a semiconductor acceleration sensor, comprising the steps of:
forming a diffused resistor on a semiconductor substrate;
thinning the back of said semiconductor substrate, having said diffused resistor by mechanical cutting;
bringing out an element region having the diffused resistor of said semiconductor substrate;
forming a supporting body for fixing the end portion of said element; and
applying electrolysis and electrifying abrasive grains to a cutting blade in the said mechanical cutting in a process of thinning the back of the diffused resistor of said semiconductor substrate by mechanical cutting.

11. A method of forming a semiconductor device, having the steps of:
forming a diffused resistor on a semiconductor substrate; and
cutting the back of a surface having said diffused resistor of said semiconductor substrate with a cutting blade applied with abrasive grains and an electric field, thereby to reduce the thickness of said semiconductor substrate.
